# EUROPÄISCHE PATENTANMELDUNG

(11) **EP 1 734 374 A1**
(43) Veröffentlichungstag der Anmeldung: **20.12.2006**
(21) Anmeldenummer: 06012388.2
(22) Anmeldetag: 16.06.2006
(51) Int. Cl.: G01R 31/28

(54) **Verfahren zum Testen eines Wafers, insbesondere Hall-Magnetfeld-Sensors und Wafer bzw. Hallsensor**

(30) Priorität: 17.06.2005 DE 102005028461
(71) Anmelder: Micronas GmbH, 79108 Freiburg (DE)
(72) Erfinder: Bidenbach, Rainer, 79279 Vörstetten (DE); Schubert, Jens, 79194 Gundelfingen (DE); Kredler, Stefan, 79194 Heuweiler (DE); Janke, Ralf, 79211 Denzlingen (DE)
(74) Vertreter: Göhring, Robert

(57) **Zusammenfassung**

Die Erfindung bezieht sich auf ein Verfahren zum Testen eines Wafers, bei dem in dem Wafer (W) ein Stromfluss erzeugt und ein resultierender physikalischer Parameter gemessen wird. Vorteilhaft wird das Verfahren dadurch, dass als der physikalische Parameter ein elektrischer Widerstand (R) gemessen wird. Vorteilhaft sind entsprechend eine Anordnung auf einem wafer bzw. ein Hall-Magnetfeld-Sensor, welche das Messen eines solchen Widerstands ermöglichen. Vorteilhaft ist auch eine Überprüfung des weiteren Signalpfades durch Erzeugung eines Signals, wie es auch von einem Magnetfeld erzeugt werden würde.

## Beschreibung

Die Erfindung bezieht sich auf ein Verfahren zum Testen eines Wafers, insbesondere eines Hall-Magnetfeld-Sensors mit den oberbegrifflichen Merkmalen des Patentanspruchs 1 bzw. 2 und auf einen Wafer bzw. einen Hallsensor mit den oberbegrifflichen Merkmalen des Patentanspruchs 16 bzw. 17.

Zum Testen von Wafern, insbesondere von Hall-Magnetfeld-Sensoren bei beispielsweise einem Produktionstest im Rahmen der Fertigung werden Magnetfelder verwendet, was mit einer Vielzahl von Nachteilen verbunden ist. Die Erzeugung genauer Magnetfelder, welche für einen Test geeignet sind, ist mit kommerziell erhältlichen sogenannten Mixed-Signal-Testsystemen ohne Zusatzgeräten nicht möglich, so dass ein zusätzlicher Hardwareaufwand erforderlich ist. Da gewöhnlich unterschiedliche magnetische Feldstärken für einen Test erforderlich sind, müssen außerdem relativ lange Einschwingzeiten der erzeugenden Spulen oder eine aufwändige Mechanik in Kauf genommen werden. Da der homogene Bereich des derart erzeugten Magnetfeldes klein ist, können nur wenige Sensoren auf einem Wafer gleichzeitig gemessen werden.

Da eine Helmholtz-Anordnung der ein solches Magnetfeld erzeugenden Spulen für einen Wafertest mit Thermochuck nicht möglich ist, kann beim Testen bzw. Proben nur ein ungenaues Magnetfeld bereitgestellt werden. Ein solcher Thermochuck stellt eine gewünschte Wafertemperatur ein, wobei der Wafer ganzflächig darauf aufliegt. Im Thermochuck fließen Ströme, welche störende Magnetfelder erzeugen. Außerdem enthält der Thermochuck normalerweise magnetische Materialien, welche das gewünschte Messmagnetfeld verzerren. Insbesondere wäre für eine Helmholtz-Anordnung eine Spule im Thermochuck nötig, was extrem kompliziert umzusetzen wäre, so dass letztendlich eine Vielzahl von Problemen für magnetische Messungen eines Wafers in Verbindung mit einem Thermochuck bestehen.

Die Aufgabe der Erfindung besteht darin, ein alternatives Verfahren zum Testen eines wafers, insbesondere zum Testen eines Hall-Magnetfeld-Sensors bzw. einen Wafer und/oder eine Hallsensoranordnung zum Durchführen eines entsprechenden Verfahrens bereitzustellen.

Diese Aufgabe wird durch die Verfahren zum Testen eines Wafers bzw. eines Hall-Magnetfeld-Sensors mit den Merkmalen der Patenansprüche 1 bzw. 2 bzw. durch einen Wafer bzw. einen Hallsensor mit den Merkmalen der Patentansprüche 16 bzw. 17 gelöst.

Vorteilhaft ist demgemäß ein Verfahren zum Testen eines Wafers, bei dem in dem Wafer ein Stromfluss erzeugt und ein resultierender physikalischer Parameter gemessen wird, wobei als der physikalische Parameter ein elektrischer Widerstand gemessen wird.

Vorteilhaft ist demgemäß Verfahren zum Testen eines Hall-Magnetfeld-Sensors, insbesondere eines Hall-Magnetfeld-Sensors auf einem Wafer, bei dem in einer Hallplatte ein Stromfluss erzeugt und ein resultierender physikalischer Parameter gemessen wird, wobei als der physikalische Parameter ein elektrischer Widerstand gemessen wird.

Vorteilhaft ist demgemäß ein Wafer zum Durchführen eines solchen Verfahrens mit zumindest einer Hallplatte, einer Schaltmatrix und Abgriffen zum Anlegen und/oder Abgreifen von Strömen und/oder Spannungen, wobei die Abgriffe Abgriffe zum Anlegen eines Messstroms aufweisen und Abgriffe zum Messen eines Stromflusses und/oder einer Spannung aufgrund des Messstroms zum Bestimmen eines elektrischen Widerstands des Wafers, der Hallplatte und/oder eines Signalpfads einschließlich der Hallplatte aufweisen.

Vorteilhaft ist demgemäß ein Hallsensor mit einer Auswerteschaltung zum Durchführen eines solchen Verfahrens mit zumindest einer Hallplatte, einer Schaltmatrix und Abgriffen zum Anlegen und/oder Abgreifen von Strömen und/oder Spannungen, wobei die Abgriffe Abgriffe zum Anlegen eines Messstroms aufweisen und Abgriffe zum Messen eines Stromflusses und/oder einer Spannung aufgrund des Messstroms zum Bestimmen eines elektrischen Widerstands des Wafers, der Hallplatte und/oder eines Signalpfads einschließlich der Hallplatte aufweisen.

Verfahrensgemäß bzw. vorrichtungsgemäß werden Testabläufe ermöglicht, mit welchen ein magnetfeldloses Testen von Wafern bzw. Hall-Magnetfeld-Sensoren ermöglich wird. Anstelle von bisher üblichen Tests von Hall-Magnetfeld-Sensoren mit Magnetfeldern werden nunmehr Testverfahren ermöglicht, bei welchen keine Magnetfelder von außen angelegt werden. Dies ermöglicht Testzeiteinsparungen, einen reduzierten Testhardwareaufwand und verbesserte Möglichkeiten von Paralleltests.

Vorteilhafte Ausgestaltungen sind Gegenstand abhängiger Ansprüche.

Vorteilhaft ist insbesondere ein Verfahren, bei dem der Widerstand des Wafers bzw. der Hallplatte gemessen wird.

Vorteilhaft ist insbesondere ein Verfahren, bei dem der Widerstand eines Signalpfads einschließlich der Hallplatte und einer Schaltmatrix gemessen wird.

Vorteilhaft ist insbesondere ein Verfahren, bei dem die Schaltmatrix als eine Schaltmatrix zum Ansteuern der Hallplatte im Betrieb zum Messen eines Magnetfelds ausgebildet ist.

Vorteilhaft ist insbesondere ein Verfahren, bei dem das Messen einer magnetischen Empfindlichkeit ohne das Anlegen eines Magnetfelds durchgeführt wird.

Vorteilhaft ist insbesondere ein Verfahren, bei dem zum Messen einer magnetischen Empfindlichkeit die Anordnung mit zumindest der Hallplatte gegen eventuelle äußere Magnetfelder abgeschirmt wird.

Vorteilhaft ist insbesondere ein Verfahren, bei dem eine weitere Messung mit einer Stromflussrichtung durch den Wafer bzw. durch die Hallplatte durchgeführt wird, welche sich von der Stromflussrichtung der vorherigen Messung unterscheidet.

vorteilhaft ist insbesondere ein Verfahren, bei dem an dem Wafer bzw. an zumindest der Hallplatte ein Messstrom angelegt wird.

Vorteilhaft ist insbesondere ein Verfahren, bei dem zum Messen eine Kopie des intern im Wafer bzw. des zumindest in der Hallplatte verwendeten Messstroms nach außen geschaltet wird.

Vorteilhaft ist insbesondere ein Verfahren, bei dem zum Durchführen der Messung eine durch den Stromfluss induzierte Hallspannungs-äquivalente Spannung abgegriffen wird.

Vorteilhaft ist insbesondere ein Verfahren, bei dem mittels eines angelegten und/oder gemessenen angelegten Stroms und einer gemessenen Spannung der Widerstand bestimmt wird.

Vorteilhaft ist insbesondere ein Verfahren, bei dem in der Anordnung gemessene Ströme innerhalb der Anordnung verstärkt werden und verstärkt zur Auswertung ausgegeben werden.

Vorteilhaft ist insbesondere ein Verfahren, bei dem das Verhalten auch einer im Signalpfad enthaltenen Auswerteschaltung zum Durchführen des Testverfahrens mitgemessen bzw. mitbestimmt wird.

Vorteilhaft ist insbesondere ein Verfahren, bei dem zur Auswerteschaltung im Signalpfad nach der Hallplatte enthaltene Komponenten gehören.

Vorteilhaft ist insbesondere ein Wafer oder Hallsensor mit einer Auswerteschaltung im Signalpfad der Hallplatte, wobei der bestimmte elektrische Widerstand den Einfluss der Auswerteschaltung mit umfasst. Die Auswerteschaltung im Signalpfad der Hallplatte ermöglich ein Testen der Auswerteschaltung durch einen angelegten Hallstrom. Dadurch ist eine Überprüfung auch des weiteren Signalpfades durch Erzeugung eines Signals möglich, wie es auch von einem Magnetfeld erzeugt werden würde.

Der komplette Signalpfad eines Sender-ICs wird vorteilhaft durch eine elektrische Stimulation getestet. Dazu werden zusätzliche Ströme in einem Testmode in die Hallplatten eingeprägt, wobei alternativ auch die Einprägung einer Spannung möglich ist, welche einen solchen Teststrom bzw. Messstrom induziert. Diese Ströme können vorteilhaft im Sensor selbst erzeugt werden. Der genaue Wert dieser Ströme kann dadurch bestimmt werden, dass diese Ströme oder Kopien von diesen Strömen in einem weiteren Testmode nach außen geschaltet werden oder alternativ von außen vorgegeben werden. Dadurch kann neben den Hallplatten der gesamte Signalpfad eines derartigen integrierten Sensors getestet werden.

Um die Hallplatten selbst zu testen, kann deren elektrischer Widerstand oder ein anderer Parameter ermittelt werden, welcher auf die magnetische Empfindlichkeit schließen lässt. Dazu kann z. B. der anregende Hallplattenstrom oder eine Kopie oder ein Bruchteil davon nach außen geschaltet und gemessen werden. In Kombination mit der dann an der Hallplatte abfallenden Spannung kann daraufhin der elektrische Widerstand bestimmt werden. Für ein gegebenes Halbleitermaterial und eine gegebene Geometrie der Hallplatte kann somit auf die Dotierstoffkonzentration und deshalb auch auf die Hallempfindlichkeit geschlossen werden. Das gleiche gilt für eine schwankende Geometrie und eine gegebene Dotierstoffkonzentration.

Ein Ausführungsbeispiel wird nachfolgend anhand der Zeichnung näher erläutert. Es zeigt:

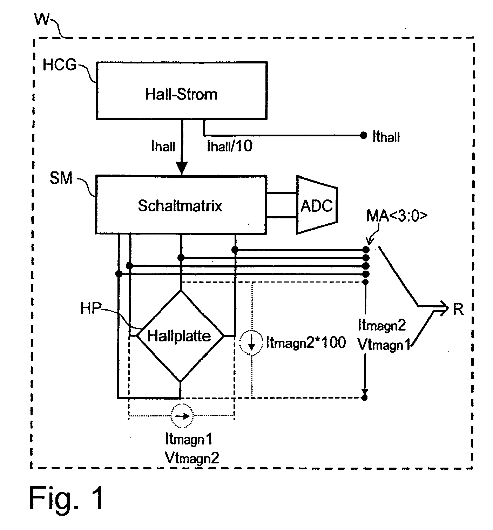

- Fig. 1: Schematisch eine Anordnung von Schaltungskomponenten zum Ausbilden eines Hallsensors auf einem Wafer.

Wie aus Fig. 1 ersichtlich ist, wird eine übliche Anordnung von Schaltungskomponenten auf einem Wafer bzw. ein entsprechender Hallsensor derart ausgestaltet, dass ein Messstrom anlegbar ist, um einzelne Komponenten, insbesondere alle Komponenten eines Signalpfades bezüglich deren elektrischem Widerstand R überprüfen zu können. Aus dem elektrische Widerstand R kann dann auf die Qualität des untersuchten Abschnitts geschlossen werden, ohne ein äußeres Magnetfeld anlegen zu müssen. Eine Anwendung ist insbesondere für alle integrierten Hallsensoren mit Auswerteschaltungen vorteilhaft umsetzbar.

Lediglich schematisch und beispielhaft ist ein Ausschnitt eines Wafers W zum Ausbilden eines Sensor-IC (IC: integrated circuit/integrierte Schaltung) dargestellt. In einen Hallstromgenerator HCG wird von einem Biasgenerator ein Referenzstrom eingegeben. Das Erzeugen der Ströme geschieht somit vorteilhafterweise in einem vorhandenen sogenannten Biasgenerator, der bereits Referenzströme und Referenzspannungen für praktisch alle Analogschaltungen auf dem Sensor liefert. Der Hallstromgenerator HCG gibt einen Hallstrom als einen Messstrom Ihall an eine Schaltmatrix SM aus. Außerdem gibt der Hallstromgenerator über einen vorzugsweise eigenständigen Ausgang einen weiteren strom Ihall/10 an einen Messstromabgriff Ithall aus. Der derart nach außen geschaltete Strom ist eine Kopie der intern verwendeten Test- bzw. Messströme Ihall, um Störeinkopplungen von außen zu vermeiden.

Die Schaltmatrix SM ist über vier Leitungen mit einer Hallplatte HP verbunden, wobei die Anschlüsse an der Hallplatte vorzugsweise an deren Eckpunkten anliegen. Mit dieser Schaltmatrix SM kann ein mittels des Hallstroms Ihall bereitgestellter Hallplattenstrom Itmagn1 in für sich bekannter Art und Weise umgeschaltet werden, um einen Stromfluss in 0°-Richtung bzw. 90°-Richtung durch die Hallplatte HP zu ermöglichen. Außerdem können mit der Schaltmatrix SM Abgriffe für das Abgreifen einer Hallspannung entsprechend umgeschaltet werden. Vorzugsweise werden Umschaltungen in 0°-Richtung, 90°-Richtung, 180°-Richtung und 270°-Richtung durch die Schaltmatrix SM bezüglich des angelegten Hallplattenstroms Itmagn1,2 bzw. der abgegriffenen Hallspannung ermöglicht, um einen durch mechanische Spannungen und Nicht-Idealitäten der Hallplatten bedingten magnetischen Offset zu vermindern.

Vorzugsweise von jeder der Leitungen zwischen der Schaltmatrix SM und der Hallplatte HP zweigt eine Leitung zu einem entsprechend vierpoligen Abgriff MA ab. Diese vier Abgriffe ermöglichen das Bereitstellen entsprechender Signale 0 bis 3, welche zur Bestimmung eines Hallplattenwiderstands R verwendet werden. Je nach Vorgaben der Schaltmatrix SM, d. h. über welche beiden Leitungen der Hallplattenstrom Itmagn1,2 an der Hallplatte HP angelegt wird, wird über zwei der vier Messabgriffe MA die dadurch erzeugte Hallplattenspannung Vtmagn1-Vtmagn2, abgegriffen. Aus dem Hallstrom Ithall und der Hallplattenspannung Vtmagn1-Vtmagn2 kann nun der Hallplattenwiderstand bestimmt werden.

Vorteilhafterweise wird durch eine solche Anordnung ermöglicht, die Hallplatte HP mit zwei voneinander unabhängigen Messungen in vertikaler bzw. horizontaler Richtung hinsichtlich deren Widerstand R zu messen.

Vorteilhafterweise kann die Schaltungsanordnung auch einen Analog-Digital-Wandler ADC aufweisen, welcher an der Schaltmatrix SM angeschlossen ist, um die Hallspannung in einen proportionalen Strom umzuwandeln. Ein solcher ADC-Eingang bietet Vorteile, ist jedoch für die Ümsetzung des Konzeptes nicht zwingend erforderlich.

Der bei einer weiteren Testmessung eingeprägte Messstrom Itmagn1,2 erzeugt wegen des Widerstandes der Hallplatte HP eine Hall-Spannungs-äquivalente Spannung, welche über den Analog-Digital-Wandler ADC die gesamte Signalverarbeitungskette stimulieren kann.

Insbesondere im Fall störender existierender Magnetfelder in der Umgebung der Messanordnung kann mittels Differenzmessungen mit unterschiedlichen Messströmen gearbeitet werden, um die Einwirkung derartiger existierender Magnetfelder herauszurechnen.

Entsprechend der Stärke der angelegten bzw. gemessenen Ströme ist eine Verstärkung oder Abschwächung solcher Ströme für Messzwecke vorteilhaft. Die Bestimmung des Widerstands R erfolgt bevorzugt dadurch, dass eine unter Umständen skalierte Kopie des Hallplattenstromes Itmagnl,2 sowie die an der Hallplatte HP abfallende Spannung Vtmagnl,2 nach außen gegeben werden, wobei dies je nach Ausgestaltung über einen parallelen Messabgriff MA oder seriell über einen einzelnen Anschlussstift als Messanschluss ausgeführt wird.

Mittels des derart bestimmten Widerstandes R in einer oder mehreren Richtungen kann auf die Geometrie der Hallplatte HP sowie auf eine resultierende Dotierstoffkonzentration bzw. dadurch auf die Hallempfindlichkeit der Hallplatte HP geschlossen werden. Sowohl Schwankungen oder Fehler bei der Geometrie der Hallplatte HP als auch Schwankungen der Dotierstoffkonzentration der Hallplatte HP können somit anhand eines abweichenden Widerstands R erkannt werden.

Vorstehend ist insbesondere die Überprüfung der Hallplatte HP durch das Bestimmen von deren Widerstand R beschrieben. Vorteilhafterweise kann jedoch nicht nur der elektrische Widerstand der Hallplatte HP bzw. bei der übergeordneten Anordnung mit mehreren Hallplatten HP der elektrische Widerstand eine Vielzahl solcher Hallplatten bestimmt werden. Besonders vorteilhaft ist das Bestimmen des elektrischen Widerstands R nicht nur der Hallplatte HP sondern, des vorzugsweise kompletten Signalpfads einschließlich der Hallplatten HP und der Schaltmatrix SM, wozu bei der Bestimmung des Widerstands R insbesondere auch der am Messstromabgriff abgreifbare Messstrom Ithall verwendet wird. Dadurch, dass Testsignale bzw. der Messstrom Ihall auch durch die Schaltmatrix SM geleitet werden, wird auch diese als Bestandteil des Signalpfads mitüberprüft. Vorteilhafterweise kann somit durch eine elektrische Stimulation ein kompletter Signalpfad, also eine Hallsensor mit Auswerteschaltung vollständig überprüft werden. Zur Auswerteschaltung in diesem Sinne gehört alles im Signalpfad, was sich insbesondere auch nach der Hallplatte HP an konstruktiven Elementen auf dem Wafer W befindet.

## Patentansprüche

1. Verfahren zum Testen eines Wafers, bei dem
- in dem Wafer (W) ein Stromfluss erzeugt wird und
- ein resultierender physikalischer Parameter gemessen wird,
**dadurch gekennzeichnet, dass**
- als der physikalische Parameter ein elektrischer Widerstand (R) gemessen wird.

2. Verfahren zum Testen eines Hall-Magnetfeld-Sensors, insbesondere eines Hall-Magnetfeld-Sensors auf einem Wafer (W) nach Anspruch 1, bei dem
- in einer Hallplatte (HP) ein Stromfluss erzeugt und
- ein resultierender physikalischer Parameter gemessen wird,
**dadurch gekennzeichnet, dass**
- als der physikalische Parameter ein elektrischer Widerstand (R) gemessen wird.

3. Verfahren nach Anspruch 1 oder 2, bei dem der Widerstand (R) des Wafers (W) bzw. der Hallplatte (HP) gemessen wird.

4. Verfahren nach einem vorstehenden Anspruch, bei dem der Widerstand (R) eines Signalpfads einschließlich der Hallplatte (HP) und einer Schaltmatrix (SM) gemessen wird.

5. Verfahren nach Anspruch 4, bei dem die Schaltmatrix (SM) als eine Schaltmatrix zum Ansteuern der Hallplatte (HP) im Betrieb zum Messen eines Magnetfelds ausgebildet ist.

6. Verfahren nach einem vorstehenden Anspruch, bei dem das Messen einer magnetischen Empfindlichkeit ohne das Anlegen eines Magnetfelds durchgeführt wird.

7. Verfahren nach einem vorstehenden Anspruch, bei dem zum Messen einer magnetischen Empfindlichkeit die Anordnung mit zumindest der Hallplatte (HP) gegen eventuelle äußere Magnetfelder abgeschirmt wird.

8. Verfahren nach einem vorstehenden Anspruch, bei eine weitere Messung mit einer Stromflussrichtung durch den wafer (W) bzw. durch die Hallplatte (HP) durchgeführt wird, welche sich von der Stromflussrichtung der vorherigen Messung unterscheidet.

9. Verfahren nach einem vorstehenden Anspruch, bei dem an dem Wafer (W) bzw. an zumindest der Hallplatte (HP) ein Messstrom (Itmagn1,2) angelegt wird.

10. Verfahren nach einem vorstehenden Anspruch, bei dem zum Messen eine Kopie des intern im Wafer (W) bzw, zumindest in der Hallplatte (HP) verwendeten Messstroms nach außen geschaltet wird.

11. Verfahren nach einem vorstehenden Anspruch, bei dem zum Durchführen der Messung eine durch den Stromfluss induzierte Hallspannungs-äquivalente Spannung abgegriffen wird.

12. Verfahren nach einem vorstehenden Anspruch, bei dem mittels eines angelegten und/oder gemessenen angelegten Stroms (Ithall) und einer gemessenen Spannung (Vtmagn1, Vtmagn2) der Widerstand (R) bestimmt wird.

13. Verfahren nach einem vorstehenden Anspruch, bei dem in der Anordnung gemessene Ströme innerhalb der Anordnung verstärkt werden und verstärkt zur Auswertung ausgegeben werden.

14. Verfahren nach einem vorstehenden Anspruch, bei dem das Verhalten auch einer im Signalpfad enthaltenen Auswerteschaltung zum Durchführen des Testverfahrens mitgemessen bzw. mitbestimmt wird.

15. Verfahren nach Anspruch 14, bei dem zur Auswerteschaltung im Signalpfad nach der Hallplatte (HP) enthaltene Komponenten gehören.

16. Wafer zum Durchführen eines Verfahrens nach einem vorstehenden Anspruch mit zumindest
- einer Hallplatte (HP),
- einer Schaltmatrix (SM) und
- Abgriffen zum Anlegen und/oder Abgreifen von Strömen und/oder Spannungen,
**dadurch gekennzeichnet dass**,
- die Abgriffe (MA) Abgriffe zum Anlegen eines Messstroms (Ihall) aufweisen und Abgriffe zum Messen einer Spannung (Vtmagn1, Vtmagn2) aufgrund des Messstroms (Ihall) zum Bestimmen eines elektrischen Widerstands des Wafers (W), der Hallplatte (HP) und/oder eines Signalpfads einschließlich der Hallplatte (HP) aufweisen.

17. Hallsensor mit Auswerteschaltung zum Durchführen eines Verfahrens nach einem der Ansprüche 1 bis 15 mit zumindest
- einer Hallplatte (HP),
- einer Schaltmatrix (SM) und
- Abgriffen zum Anlegen und/oder Abgreifen von Strömen und/oder Spannungen,
**dadurch gekennzeichnet dass**,
- die Abgriffe (MA) Abgriffe zum Anlegen eines Messstroms (Ihall) aufweisen und Abgriffe zum Messen einer Spannung (Vtmagn1, vtmagn2) aufgrund des Messstroms (Ihall) zum Bestimmen eines elektrischen Widerstands des Wafers (W), der Hallpl atte (HP) und/oder eines Signalpfads einschließlich der Hallplatte (HP) aufweisen.

18. Wafer oder Hallsensor nach Anspruch 16 bzw, 17 mit einer Auswerteschaltung im Signalpfad der Hallplatte (HP) zum Testen der Auswerteschaltung durch einen angelegten Hallstrom (Ithall).
